Europäisches Patentamt

(19) European Patent Office

Office européen des brevets

(11) Publication number: **0 068 072**
A2

(12) # EUROPEAN PATENT APPLICATION

(21) Application number: **82101870.2**

(22) Date of filing: **09.03.82**

(51) Int. Cl.³: **H 01 L 29/72, H 01 L 21/263,**
**H 01 L 21/76**

(30) Priority: **01.07.81 US 279481**

(43) Date of publication of application: **05.01.83**
**Bulletin 83/1**

(84) Designated Contracting States: **DE FR GB**

(71) Applicant: **Rockwell International Corporation, 2230 East Imperial Highway, El Segundo, California 90245 (US)**

(72) Inventor: **Soclof, Sidney Isaac, 6419 N. Lemon, San Gabriel, CA 91775 (US)**

(74) Representative: **Wagner, Karl H., P.O. Box 246 Gewürzmühlstrasse 5, D-8000 Munich 22 (DE)**

(54) **Lateral PNP transistor and method.**

㊗ The invention is a sub-micron dielectrically isolated PNP transistor and method of making the same wherein hundreds of such transistors may be fabricated on a single P doped chip with each transistor comprising an active region surrounded by field oxide regions, $P^+$ spaced-apart doped portions within said active regions and oxide plus N doping surrounding each $P^+$ region; electrical connections to the base N portion and the collector and emitter $P^+$ portions. These regions are established by first forming boundary recesses about each active portion where a transistor will be formed, depositing boron in the recesses to form $P^+$ regions in the transistor-active region adjacent the recesses, deepening the recesses, diffusing aresenic into the deepened recesses to dope the substrate N type beneath the $P^+$ regions and also between the $P^+$ regions, and patterning and metallizing the substrate to develop the electrical connections of the base, emitter and collector electrodes. Optionally, the substrate may be $N^+$ doped adjacent its surface, between the collector and emitter, to force current flow away from the surface.

## LATERAL PNP
## TRANSISTOR AND METHOD

### Field of the Invention

This invention is a novel structure and method for forming a sub-micron bipolar dielectrically isolated transistor utilizing VLSI chip processing steps to fabricate hundreds of such devices simultaneously.

### Background of the Invention

Techniques extracted from the prior art come from the field of sub-micron fabrication technology wherein the dimensional resolution is now comparable to or even smaller than the thicknesses of the thermally grown silicon oxide layers on silicon. Also the dimensions are now comparable to or even smaller than the base widths used for double diffused transistors, i.e., 0.4-1.0 micrometers. From these techniques the novel structure and method for the bipolar transistor with greatly reduced parasitic capacitance and resistance have been devolved in unique combination and sequence.

Summary of the Invention

The invention is a novel lateral PNP transistor formed on a P substrate by making a recess in the substrate bounding the region for the transistor, N doping the substrate transistor active region via the recess, deepening the recess portions into the original P substrate, P+ doping opposed edge portions of the recess via said recess; and filling the recess with field oxide. Conventional electrical connections are established to each of the P+ spaced-apart portions and to the N doped intermediate portions with the latter comprising the base for the transistor and the former P+ regions being the collector and emitter.

Brief Description of the Drawings

FIG. 1 is a view in cross-section through a region of the substrate where a single transistor will be formed showing photoresist outlining the regions to be recessed into the substrate and also protecting the active region of the transistor;

FIG. 2 shows the substrate slotted along the boundary recess regions with N doping introduced to the substrate active region via the recess edges and bottom.

FIG. 3 shows the P+ doping of sidewalls or edges of the recess portions;

FIG. 4 shows the slots or recess portions deepened beyond the P+ region;

FIG. 5 shows the recessed regions extending into the P doped substrate, beyond the P+ doped regions and the boundary recesses filled with oxide;

FIG. 6 shows the N+ implanting of the upper substrate doped active region and the results of the patterning and metallization steps; and

FIG. 7 is a plan view of a single lateral PNP transistor showing boundary recess(es) filled with field oxide and the emitter, base and collector electrodes with electrical connections included.

Description of the Preferred Embodiment

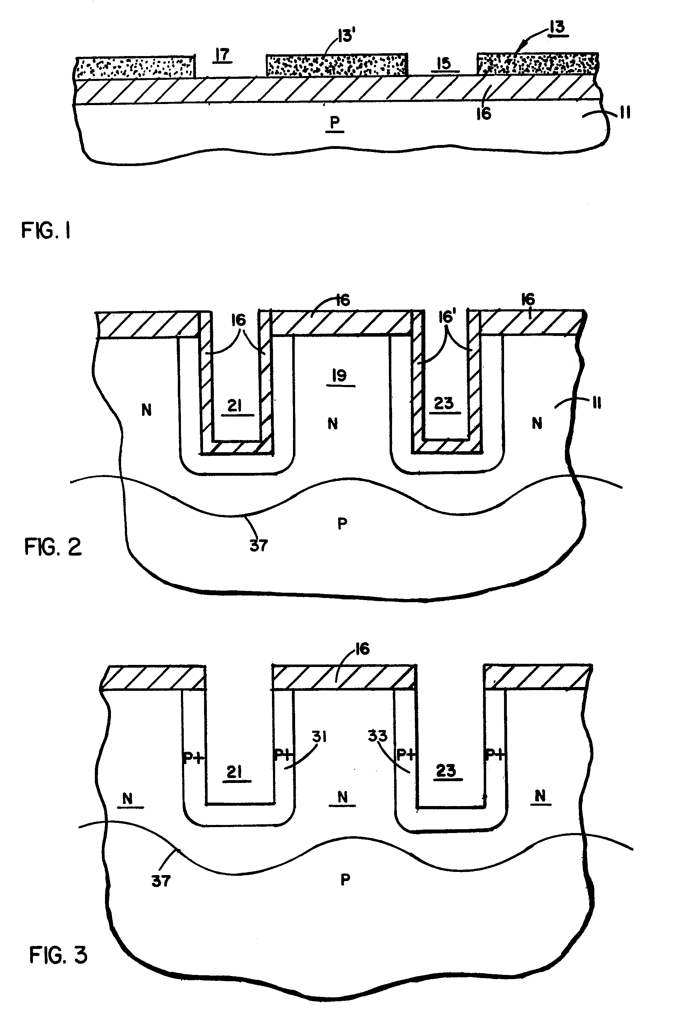

The drawings including FIGs 1-6 show a preferred fabrication method for the structure of FIG. 7 with the steps being recited in preferred order and each function accomplished by a preferred specified processing step.

In FIG. 1, the P type substrate 11 may comprise silicon or silicon-on-sapphire. The substrate 11 is first optionally oxidized, as shown at 16. It is then covered with a photoresist layer 13 which is masked, exposed to actinic radiation, and the photoresist removed where soluble in the regions 15 and 17 which outlines the portions of the substrate to be slotted or recessed around the boundary of the active region 19 (FIG. 2) for a single transistor, shown as that region covered by the photoresist 13'.

In FIG. 2, the slots 21 and 23 have been milled into substrate 11 in the regions 17 and 15 while the other regions were protected by the photoresist 13 and optional oxide. It will be understood that slots or recesses 21 and 23, as shown in FIG. 2, only bound the active region 19 on two sides, but in reality this boundary recessing or slotting extends completely about the transistor active region 19, as illustrated in FIG. 7 wherein the slot portions 21 and 23 are seen as bounding two sides of region 19, whereas slots 25 and 27 bound the other two sides, such that the entire active area 19 is bounded by recesses or slots (i.e.) a peripheral recess.

Returning to FIG. 2, the next step in the preferred process is the deposition of arsenic or phosphorous into slots 21 and 23 to form the N doped regions beneath and between the slots 21 and 23 within substrate 11 above the original P doped substrate line 37.

Following the N doping step to form the P+ regions, silicon oxide is grown over the entire exposed surface of substrate 11, as shown at 16 and 16'. If oxide layer 16 was originally employed (as in FIG. 1) it is merely thickened in this step.

In FIG. 3, boron has been diffused into the substrate via the slots 21, 23 to form the P+ regions 31 and 33.

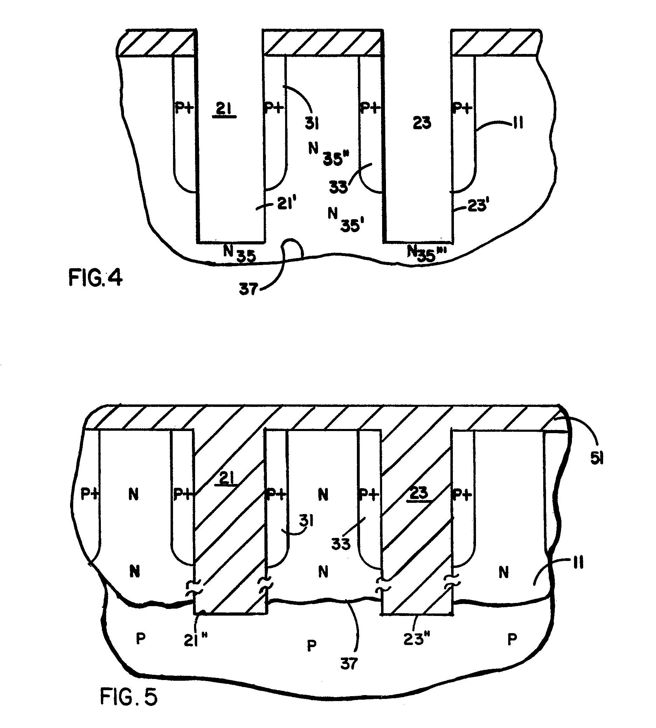

Proceeding to FIG. 4, the slots 21 and 23 are milled deeper, as shown by the extensions 21' and 23' which penetrate substrate 11 deeper than the P+ doped regions 31 and 33. Also, any remaining silicon oxide lining slots 21 and 23, as deepened, is removed following conventional practices. Here the N type regions are indicated as 35, 35', 35'' and 35'''. The N to P region of substrate 11 is now roughly defined by the line 37. It will be seen that the N region is beneath the slot 21 extension 21' and the slot extension 23 extension 23', and also occupies the region between the P+ active portions 31 and 33.

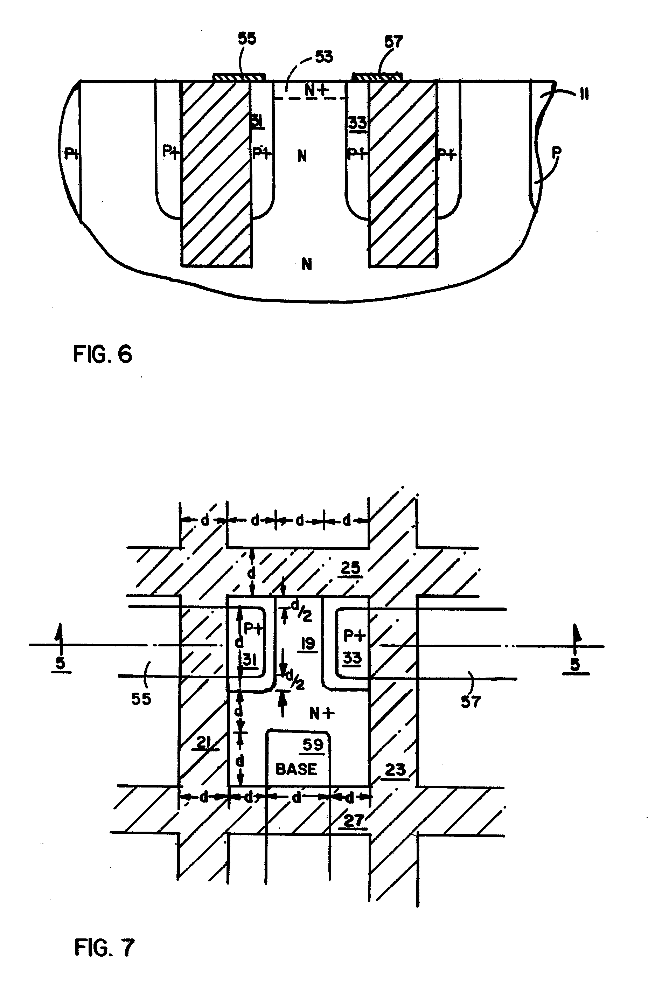

In FIG. 5, the third deepening of slots 21 and 23 is effected, again preferably by ion milling, to extend them to their bottoms 21'' and 23'' which now penetrate the P substrate region beneath curve 37. This third deepening may be accomplished in the second deepening of FIG. 4, but is illustrated in FIGs. 4 and 5 to emphasize the underlying P isolation in contact with the slot oxide filling for total separation of the active regions. The substrate 11 is then oxidized sufficiently to fill the slots 21 and 23 completely with silicon oxide and to cover the substrate 11 with a surface layer 51 of silicon oxide.

At this stage it may be noted that the silicon oxide of the recesses or slots completely electrically isolates the P+NP+ active region of the transistor device being formed in the active region within this isolation boundary.

In FIG. 6 the oxide has been stripped completely off the top, (shown as the oxide 51), as by etching, to allow for the optional arsenic N+ implant, indicated by the N+ designation at 53. One way of achieving this type doping is to use low energy arsenic diffusion for the N regions and high energy arsenic diffusion for the N+ regions.

Also, in FIG. 6, a layer of metallization has been applied to the upper surface of the substrate 11, and it has been covered by photoresist and patterned, removed where soluble, and the metallization etched away to leave the particular metal conductors 55 and 57 shown in contact with the P+ region 31 and P+ region 33. In the same manner the base lead 59 (FIG. 7) has been formed from the metallization and patterning steps, as shown in FIG. 6 such that electrode connections are made to emitter region 31, collector region 33 and base region 59.

It will be noted from FIG. 7 that the sectional view for FIG. 6 is taken along the plane 5-5. Also, the transistor of FIG. 7 is sized 4d X 5d to occupy an area of $20d^2$, wherein d is a dimension of 0.4 to 1 micrometer. It may be seen that the vertical dimension comprises the first d for the base region 59, the second d for the spacing between the base region and the emitter region 31, the third d for the width of the emitter region 31 and $\frac{d}{2} + \frac{d}{2}$ for the spacing between electrode 55 and the extremes of the N+ region 31 with the fifth d encompassing one recess 25. The dimension in the orthogonal direction utilizes the first d for the width of the recess 21, the second d for the spacing to the electrode 59, the third d for the width of the base electrode 59 and the fourth d measures to recess 23. In summary, these bipolar transistors have extremely small areas and the parasitic capacitance and resistance is also greatly reduced. The total size of the transistor is not much greater than the active area of the transistor. The base emitter junction capacitance and the collector base capacitance are made very small. Also, the base spreading resistance is small. Since the base width can be made small, i.e., approaching approximately 0.1 micrometers, a high gain and low transit time can be achieved. Also, a symmetrical transistor with a very low collector to emitter saturation voltage is available. Further, the collector resistance is also very small.

While departures from the aforementioned process can be made by substituting doping materials for ion-implanting or ion-implanting steps for doped materials, nevertheless the principles of the invention are uniquely set forth in the appended claims which it intended measure the scope of this invention, wherein:

What is Claimed is;

1. An array of sub-micron dimensioned PNP lateral transistors formed on a substrate P doped, each comprising in combination:

spaced apart slots in the substrate through which N type doping is received into the adjacent substrate to N dope the transistor active region of the substrate;

said slots filled with field oxide and surrounding each region where a transistor will be formed; and,

P+ doping on the inner sides of the spaced apart slots within said regions comprising emitter and collector electrode areas;

said slots deepened into the original P substrate;

said slots filled with field oxide and surrounding each region where a transistor will be formed; and,

N doping implanted in the substrate in said active region separately of the P+ regions and enhanced to N+ areas to comprise base electrode areas; and,

metallization connections to each P+ and N+ electrode area.

2. The transistor of Claim 1, wherein:

said region is substantially rectangular having a length of 5d and a width of 4d wherein d is 0.4 to 1 micrometer.

3. The transistor of Claim 1, wherein:

the P+ doping is diffused through said slots after they have been deepened following the N doping in order that the P doping underlies the P+ doping and the N doping is between the P+ doping; and,

the N doping is diffused through the substrate surface in said regions at least between P+ doped substrate area to comprise the enhanced N+ regions.

4. The transistor of Claim 2, wherein:

N+ doping is implanted through said substrate surface in said regions at least between P+ doped substrate areas after said P+ diffusion.

5. The transistor of Claim 1, wherein:

the P+ doping is diffused through said slots after the N doping overlies the substrate P doping; and,

slots are deepened into said original P substrate.

6. The transistor of Claim 5, wherein:

N doping is implanted through said substrate surface in said region over the N doping to comprise N+ regions.

7. A method for forming an array of sub-micron dimensioned PNP lateral transistors on a substrate doped P type, wherein each transistor is formed comprising the following steps:

masking the substrate to outline boundary regions for each active region to comprise a transistor;

slotting the substrate in said boundary regions;

doping the substrate via the slotted boundary regions to render regions of the substrate adjacent the boundary regions N doped;

doping the substrate via the slotted boundary regions to render regions of the substrate adjacent thereto P+ regions;

deepening the slotted boundary regions into the original P doped substrate;

filling the deepened slotted boundary regions with field oxide;

optionally doping the regions adjacent the substrate surface between the P+ regions N+; and,

metallizing and patterning said substrate surface to provide electrical connections to each of said P+ regions and to said N+ region.

8. The method of Claim 7, wherein;

said slotting and deepening is effected by ion milling.

9. The method of Claim 8, wherein;

said P+ doping is achieved by diffusion following oxidation of the substrate and removal of the oxide from the slotted boundary regions.

10. The method of Claim 9, wherein;

said N doping is achieved by implanting arsenic or phosphorous

11. The method of making a PNP lateral transistor on a P doped substrate, comprising the steps of:

forming a recess in the substrate bounding the region for the transistor;

N doping the substrate adjacent said region;

P+ doping spaced apart portions of said regions;

Deepening the recess into the original P substrate;

filling said recess with field oxide; and,

establishing electrical connections to each of said P+ spaced apart portions and to the N doped portion of said region.

12. A PNP transistor having an active region formed on a P doped substrate, comprising the steps of;

recessing the substrate substantially along the periphery of the transistor active region;

N doping the transistor active region via portions of said recessing;

selectively P doping the transistor active region through portions of the recesses formed by said recessing to form P+ regions;

deepening the recessing into said P substrate;

filling said recesses with substrate oxide substantially to isolate the active region from said substrate; and,

forming conductors to different portions of said active region to serve as emitter, base and collector electrode connections.

13. The transistor of Claim 12, wherein:

The emitter and collector regions are the P doped regions; and,

the base region is enhanced to N+.

FIG. 1

FIG. 2

FIG. 3

**FIG.4**

**FIG.5**

FIG. 6

FIG. 7